# EUROPÄISCHE PATENTSCHRIFT

(11) **EP 2 989 660 B1**
(45) Veröffentlichungstag und Bekanntmachung des Hinweises auf die Patenterteilung: **04.01.2017**
(21) Anmeldenummer: 14780861.2
(22) Anmeldetag: 06.10.2014
(51) Int. Cl.: H01L 25/07, H01L 25/16, H02M 1/34

(54) **HALBLEITERSTAPEL FÜR UMRICHTER MIT SNUBBER-KONDENSATOREN**
SEMICONDUCTOR STACK FOR CONVERTER WITH SNUBBER CAPACITORS
EMPILEMENT DE SEMI-CONDUCTEURS POUR CONVERTISSEUR ÉQUIPÉ DE CONDENSATEURS D'AMORTISSEMENT

(30) Priorität: 04.10.2013 DE 202013104510 U
(43) Veröffentlichungstag der Anmeldung: 02.03.2016
(73) Patentinhaber: ABB Schweiz AG, 5400 Baden (CH)
(72) Erfinder: SENTURK, Osman, CH-5300 Turgi (CH); STEIMER, Peter, CH-5420 Ehrendingen (CH)
(74) Vertreter: ABB Patent Attorneys
(86) Internationale Anmeldenummer: PCT/EP2014/071296
(87) Internationale Veröffentlichungsnummer: WO 2015/049387

(56) Entgegenhaltungen:
- EP-A2- 0 751 612
- US-A- 5 045 924

## Beschreibung

### GEBIET DER ERFINDUNG

Die Erfindung betrifft einen Halbleiterstapel bzw. Presspack für einen Leistungsumrichter.

### HINTERGRUND DER ERFINDUNG

Bei vielen Leistungselektronik-Schaltungen pendelt bzw. kommutiert der Strom von einem Halbleitergerät zu einem anderen äquivalenten Halbleitergerät über eine Kommutierungsschleife. Beispielsweise umfassen Zweipunktumrichter zwei Halbleiterschalter, die mit einem Kondensator verbunden sind und somit mit dem Kondensator eine Kommutierungsschleife bilden. In der Regel weist die Kommutierungsschleife eine gewisse Streuinduktivität auf, die beispielsweise durch die Leiter, die die Halbleiterbauteile verbinden und die Induktivität des Kondensators erzeugt wird.

Wenn eine Kommutierung des Stroms zwischen den beiden Schaltern auftritt, fällt der Strom wegen der Streuinduktivität nicht schlagartig ab, sondern ist zeitlich abhängig, was zu Spannungsspitzen führt, die die Halbleiterschalter belasten. Da jeder Halbleiterschalter auch nur eine begrenzte Spannung an seinen Eingängen blockieren kann, reduziert eine hohe Streuinduktivität auch die Leistungsfähigkeit bzw. Schaltgeschwindigkeit des Zweipunktumrichters.

Beispielsweise kann ein Kondensator mit niedriger Induktivität, wie etwa ein Filmkondensator, gewählt werden um die Streuimpedanz zu senken. Auch können zwischen dem Kondensator und den Halbleiterschaltern Verbindungen mit niedriger Induktivität eingesetzt werden, wie etwa ebene Busschienen, verdrehte Leitungen, usw.

Auch ist es möglich, einen Snubber-Kondensator (Dämpfungskondensator) räumlich nahe den Halbleiterschaltern anzuordnen, was die Kommutierungsschleife und damit die Streuinduktivität verkleinern kann.

Leistungs-Halbleiterschalter, die in der Regel flächig ausgeführt sind, werden beispielsweise zusammen mit Kühlelementen in einem Stapel angeordnet und können zu einem sogenannten Presspack verbunden werden. Der Presspack bzw. Stapel kann auch den Snubber-Kondensator umfassen, der seitlich am Presspack bzw. Stapel angeordnet sein kann.

Die EP 0 751 612 A2 offenbart eine Stromrichterschaltungsanordnung mit Halbleiterschaltern und Kondensatoren und die US 5 045 924 offenbart ein Gehäuse für einen Halbleiterstapel eines Umrichters.

### ZUSAMMENFASSUNG DER ERFINDUNG

Es ist Aufgabe der Erfindung, einen Halbleiterstapel für einen Umrichter bereitzustellen, der kompakt gebaut ist und der eine niedrige Streuinduktivität in der Kommutierungsschleife aufweist.

Diese Aufgabe wird durch den Gegenstand des unabhängigen Anspruchs gelöst. Weitere Ausführungsformen der Erfindung ergeben sich aus den abhängigen Ansprüchen und aus der folgenden Beschreibung.

Die Erfindung betrifft einen Halbleiterstapel für einen Umrichter bzw. eine Halbbrücke, die zusammen mit einem Zellenkondensator einen Umrichter bilden kann. Der Halbleiterstapel kann auch eine unipolare oder bipolare Zelle (in der Regel ohne Zellenkondensator) für einen modularen Multiniveauumrichter umfassen. Unter einem Halbleiterstapel kann dabei ein Stapel von Halbleiterelementen und weiterer Bauelemente, wie etwa Kühlelemente, verstanden werden, die über einem gemeinsamen Rahmen miteinander verbunden sind.

Gemäß einer Ausführungsform der Erfindung umfasst der Halbleiterstapel zwei in Reihe geschaltete Halbleiterschalter, wie etwa Transistoren, Thyristoren, IGBTs, IGCTs, RC-IGBTs und/oder RC-IGCTs; zwei Anschlüsse zum Anschließen eines Zellenkondensators, die von den beiden Halbleiterschaltern miteinander verbunden werden; wenigstens ein zwischen den Halbleiterschaltern angeordnetes Kühlelement, das beispielsweise elektrisch leitend sein kann und die beiden benachbarten Halbleiterschalter elektrisch verbindet; einen Rahmen, mit dem die Halbleiterschalter und das Kühlelement aneinander fixiert sind und der die Anschlüsse bereitstellt; und wenigstens zwei mechanisch am Rahmen fixierte Snubber-Kondensatoren, die parallel geschaltet sind, mit den Anschlüssen verbunden sind und die jeweils eine Kommutierungsschleife mit den Halbleiterschaltern bilden.

Auf diese Weise kann ein baulich kompakter Halbleiterstapel bereitgestellt werden, der eine niedrige Streuinduktivität in den Kommutierungsschleifen aufweist. Da parallel geschaltete Induktivitäten zu einer niedrigeren Induktivität führen, führen mehrere (zwei, drei, vier, usw.) Kommutierungsschleifen zu einer Verminderung der Streuinduktivität. Da nicht ein großer, sondern mehrere kleine Kondensatoren um die Halbleiterstapel herum verteilt werden können, kann zusätzlich der Bauraum besser ausgenutzt werden.

Gemäß einer Ausführungsform der Erfindung umfasst der Halbleiterstapel weiter wenigstens vier mechanisch am Rahmen fixierte Snubber-Kondensatoren. Die Kondensatoren können beispielsweise paarweise seitlich am Halbleiterstapel angebracht werden, beispielsweise über eine gemeinsame Busschiene. Zwei Snubber-Kondensatoren können an gegenüberliegenden Seiten des Halbleiterstapels angeordnet werden. Zwei Snubber-Kondensatoren können alternativ oder zusätzlich räumlich nebeneinander an einer Seite des Halbleiterstapels angeordnet werden.

Gemäß einer Ausführungsform der Erfindung sind die Snubber-Kondensatoren gleichartig ausgeführt. Die Snubber-Kondensatoren können die gleiche Form, die gleiche Größe und/oder die gleiche Kapazität aufweisen. In der Regel wird ein Snubber-Kondensator einen zylinderförmigen Körper mit elektrischen Kontakten an den Enden aufweisen.

Gemäß einer Ausführungsform der Erfindung umfasst der Halbleiterstapel weiter eine Snubber-Diode. Die parallel geschalteten Snubber-Kondensatoren können über eine Diode, die Schwingungen bzw. Resonanzen in den Kommutierungsschleifen verhindern kann, mit einem Ende der beiden in Reihe geschalteten Halbleiterschalter verbunden sein.

Gemäß einer Ausführungsform der Erfindung umfasst der Halbleiterstapel weiter einen Snubber-Widerstand. Die parallel geschalteten Snubber-Kondensatoren können über einen Snubber-Widerstand mit einem Ende der beiden in Reihe geschalteten Halbleiterschalter verbunden sein. Der Snubber-Widerstand kann parallel zu der Snubber-Diode geschaltet sein.

Gemäß einer Ausführungsform der Erfindung umfasst der Halbleiterstapel weiter eine Drossel-Induktivität. Die Drossel-Induktivität kann zum Einstellen bzw. Steuern der Induktivität der Kommutierungsschleifen und/oder des Leiterkreises zum Zellenkondensator verwendet werden. Beispielsweise kann die Drossel-Induktivität in die Kommutierungsschleifen eingefügt sein und/oder kann den Snubber-Widerstand mit der Snubber-Diode verbinden.

Gemäß einer Ausführungsform der Erfindung umfasst der Halbleiterstapel weiter ein erstes Paar und ein zweites Paar von in Reihe geschalteten Halbleiterschaltern, die jeweils paarweise mit zwei Zellenkondensatoren verbindbar sind. Der Halbleiterschalter kann zwei in Reihe geschaltete Halbbrücken aufweisen bzw. dazu ausgeführt sein zwei in Reihe geschaltete (Teil-)Umrichter zu bilden.

Gemäß einer Ausführungsform der Erfindung umfasst der Halbleiterstapel wenigstens zwei mechanisch am Rahmen fixierte erste Snubber-Kondensatoren, die parallel geschaltet sind und die jeweils eine Kommutierungsschleife mit dem ersten Paar von Halbleiterschaltern bilden; und wenigstens zwei mechanisch am Rahmen fixierte zweite Snubber-Kondensatoren, die parallel geschaltet sind und die jeweils eine Kommutierungsschleife mit dem zweiten Paar von Halbleiterschaltern bilden. Der Halbleiterstapel kann für jede der Halbbrücken bzw. Teilumrichter eine Snubber-Schaltung, so wie oben bereits beschrieben, aufweisen. Auch die Komponenten der beiden Snubber-Schaltungen und insbesondere die Snubber-Kondensatoren können seitlich am Halbleiterstapel fixiert sein.

Gemäß einer Ausführungsform der Erfindung sind die (ersten und/oder zweiten) Snubber-Kondensatoren über eine (erste und/oder zweite) Busschiene miteinander verbunden. Auf diese Weise kann eine Anordnung aus zwei, vier oder mehreren Kondensatoren zueinander fixiert werden. Die (erste und/oder zweite) Busschiene kann am Halbleiterstapel fixiert werden, wodurch die Kondensatoren und damit auch die durch sie bereitgestellten Kommutationsschleifen mechanisch fest mit dem Halbleiterstapel verbunden sind.

Gemäß einer Ausführungsform der Erfindung sind die ersten Snubber-Kondensatoren mit den zweiten Snubber-Kondensatoren über eine Busschiene miteinander verbunden, die am Halbleiterstapel fixiert sein kann. Diese Busschiene kann beispielsweise direkt an einem elektrisch leitenden, angrenzenden Kühlkörper befestigt sein, der beispielsweise zwischen zwei Halbleiterschaltern im Halbleiterstapel angeordnet ist.

Mit mehreren Kommutierungsschleifen kann auch der Raum um den Halbleiterstapel besser ausgenutzt werden, da freie Räume dazu genutzt werden können weitere Kondensatoren aufzunehmen.

### KURZE BESCHREIBUNG DER FIGUREN

Im Folgenden werden Ausführungsbeispiele der Erfindung mit Bezug auf die beiliegenden Figuren detailliert beschrieben.
Fig. 1 zeigt ein Schaltdiagramm eines Zweipunktumrichters.
Fig. 2 zeigt Schaltsymbole für mögliche Halbleiterschalter.
Fig. 3 zeigt ein Schaltdiagramm für einen Halbleiterstapel gemäß einer Ausführungsform der Erfindung.
Fig. 4 zeigt schematisch einen Halbleiterstapel gemäß einer Ausführungsform der Erfindung.
Fig. 5 zeigt schematisch einen Halbleiterstapel gemäß einer weiteren Ausführungsform der Erfindung.
Fig. 6 zeigt ein Schaltdiagramm für einen Halbleiterstapel gemäß einer weiteren Ausführungsform der Erfindung.
Fig. 7 zeigt eine dreidimensionale Ansicht eines Halbleiterstapels gemäß einer Ausführungsform der Erfindung.

Die in den Figuren verwendeten Bezugszeichen und ihre Bedeutung sind in zusammenfassender Form in der Liste der Bezugszeichen aufgeführt. Grundsätzlich sind identische oder ähnliche Teile mit den gleichen Bezugszeichen versehen.

### DETAILLIERTE BESCHREIBUNG VON AUSFÜHRUNGSBEISPIELEN

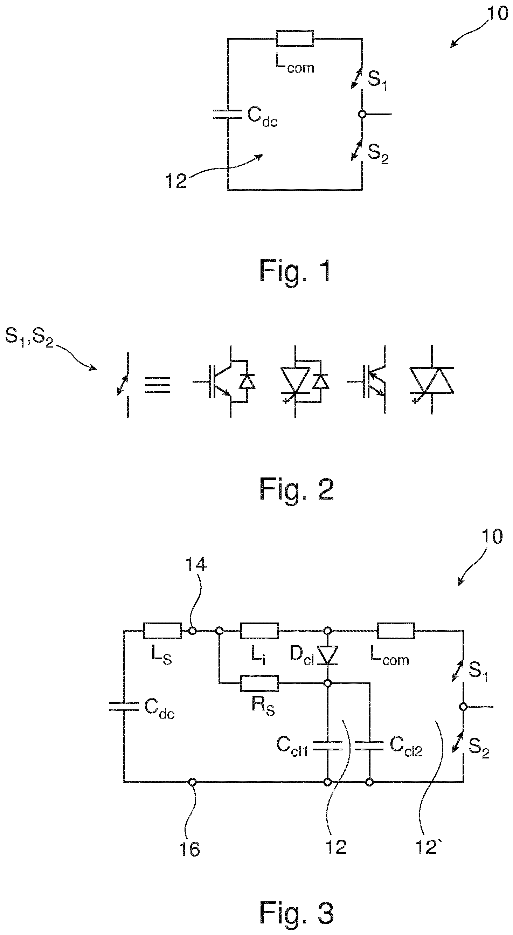

In der Fig. 1 ist ein spannungsgeführter Zweipunktumrichter 10 schematisch dargestellt, der eine Kommutierungsschleife 12 zwischen zwei Halbleiterschaltern S₁, S₂ umfasst, in der ein Kondensator C_{dc} angeordnet ist. Diese Schleife 12 weist eine Streuinduktivität oder Kommutierungsimpedanz L_{com} auf.

Wenn eine Kommutierung des Stroms zwischen den beiden Schaltern auftritt, fällt der Strom *i* wegen der Streuinduktivität nicht schlagartig ab, sondern ist zeitlich abhängig, was zu Spannungsspitzen führt, die die Halbleiterschalter belasten. Die auftretende überspannung *v* berechnet sich dabei mit v*=L_{com}^{*}di*/*dt.*

Wie in der Fig. 2 dargestellt ist, können die Halbleiterschalter S₁, S₂ beispielsweise einen Transistor, Thyristor, IGBT, IGCT, RC-IGBT, RC-IGCT etc. umfassen.

Fig. 3 zeigt einen Zweipunktumrichter 10, der weitere Schaltkomponenten umfasst, um durch die Streuinduktivität L_{com} erzeugte Spannungsspitzen zu verhindern oder zumindest zu reduzieren. Bei dem in der Fig. 3 gezeigten Schaltkreis handelt es sich um einen sogenannten RCLD-Dämpfungskreis. Beispielsweise sind die Komponenten des Umrichters außer dem Zellkondensator C_{dc} in einem gemeinsamen Modul/Stapel zusammengefasst, wobei der Zellkondensator C_{dc} über Anschlüsse 14 und 16 mit dem Modul/Stapel verbunden werden kann.

Zunächst kann ein Snubber-Kondensator C_{cl1} parallel zu dem Zellkondensator C_{dc} und parallel zu den in Reihe geschalteten Halbleiterschaltern S₁, S₂ geschaltete werden, der sich in räumlicher Nähe zu den beiden Halbleiterschaltern S₁, S₂ befindet. Auf diese Weise wird die Kommutierungsschleife 12 verkleinert und die Induktivität der Leitungen vermindert bzw. die Induktivität Ls aus der Kommutierungsschleife 12 ausgekoppelt.

Im Falle ungedämpfter Oszillationen (Resonanzen) zwischen dem Snubber-Kondensator und dem Zell- bzw. Hauptkondensator C_{dc}, können eine Snubber-Diode (Dämpfungsdiode) D_{cl} und ein Snubber-Widerstand (Dämpfungswiderstand) Rs in die Kommutierungsschleife 12 eingefügt werden.

Wenn der Abschaltstrom bzw. dessen zeitliche Änderung di/dt gesteuert werden soll, (beispielsweise zwischen der Diode D_{cl} und den Halbleiterschaltern S₁, S₂) und/oder wenn zumindest ein Teil der Schaltverluste der Halbleiterschalter S₁, S₂ in den Snubber-Widerstand Rs geführt werden soll (beispielsweise für IGBTs als Halbleiterschalter S₁, S₂), kann eine di/dt-Drossel-Induktivität Lᵢ eingeführt werden. Die Induktivität Lᵢ kann dabei zwischen den Zellkondensator C_{dc} und einen der Halbleiterschalter S₁, S₂ eingefügt werden. Dabei kann ein Ende des Widerstand Rs zwischen den Zellkondensator und die Induktivität Lᵢ geschaltet sein und/oder ein Ende der Diode D_{cl} zwischen die Induktivität Lᵢ und den Halbleiterschalter S₁, S₂.

Es ist auch möglich, dass der Widerstand Rs, die Induktivität Lᵢ und die Diode D_{cl} nicht mit dem Anschluss 14, sondern mit dem anderen Anschluss 16 verbunden sind.

Um die Streuinduktivität weiter zu vermindern, können nicht nur ein Snubber-Kondensator sondern eine Mehrzahl von parallel geschalteten Snubber-Kondensatoren C_{cl1}, C_{c12} eingesetzt werden, die eine Mehrzahl von Kommutierungsschleifen 12, 12' bilden.

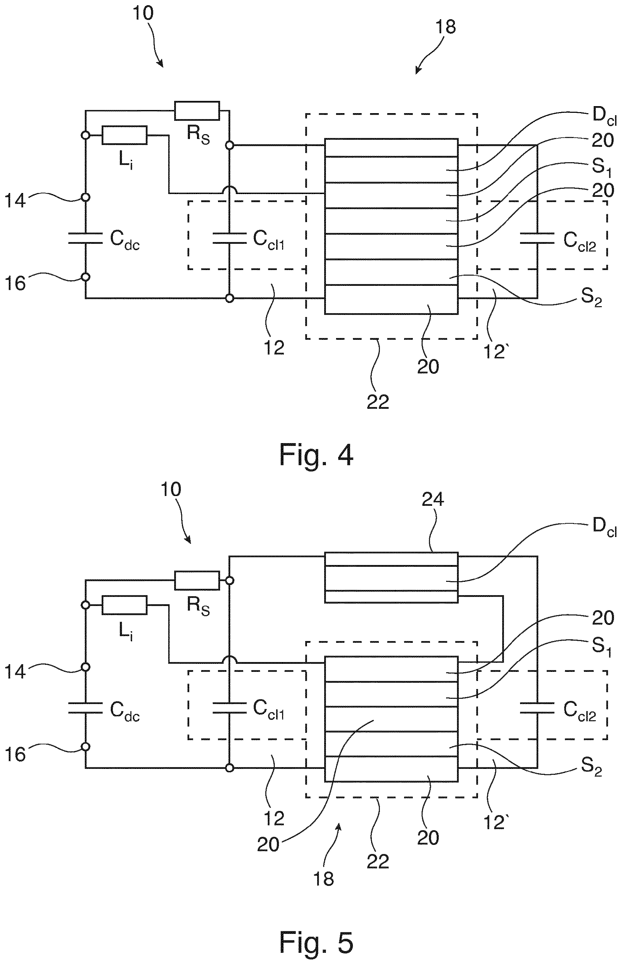

Wie in der Fig. 4 gezeigt ist, können die beiden Halbleiterschalter S₁, S₂ und die Diode D_{cl} zusammen in einem Stapel 18 angeordnet werden. Dabei ist zwischen zwei Halbleiterbauelementen S₁, S₂ jeweils ein Kühlelement 20 bzw. Kühlplatte 20 angeordnet.

Der Stapel kann einen Rahmen 22 aufweisen, mit dem die Bauelemente S₁, S₂, D_{cl} und 20 zusammengepresst werden können. Auf diese Weise entsteht ein sogenannter Presspack.

Wie in der Fig. 5 gezeigt ist, kann die Diode D_{cl} auch in einem zusätzlichen Stapel 24 angeordnet werden. Der Stapel 18 umfasst dann lediglich die Halbleiterschalter S₁, S₂ und die Kühlelemente 20.

Der Stapel 18 kann mit den Kondensatoren C_{cl1} und C_{cl2} sowie mit den anderen Elementen Rs, Lᵢ mittels Kabeln, Leitungen und/oder Busschienen verbunden werden.

Weiter sind die Kondensatoren C_{cl1} und C_{c12} sowie optional die anderen Bauelemente Rs, Lᵢ mit dem Stapel 18 und insbesondere dessen Rahmen 18 mechanisch verbunden.

Insbesondere formen die an den Seiten des Stapels 18 angeordneten Kondensatoren C_{cl1} und C_{c12} zwei parallele Kommutationsschleifen 12, 12'.

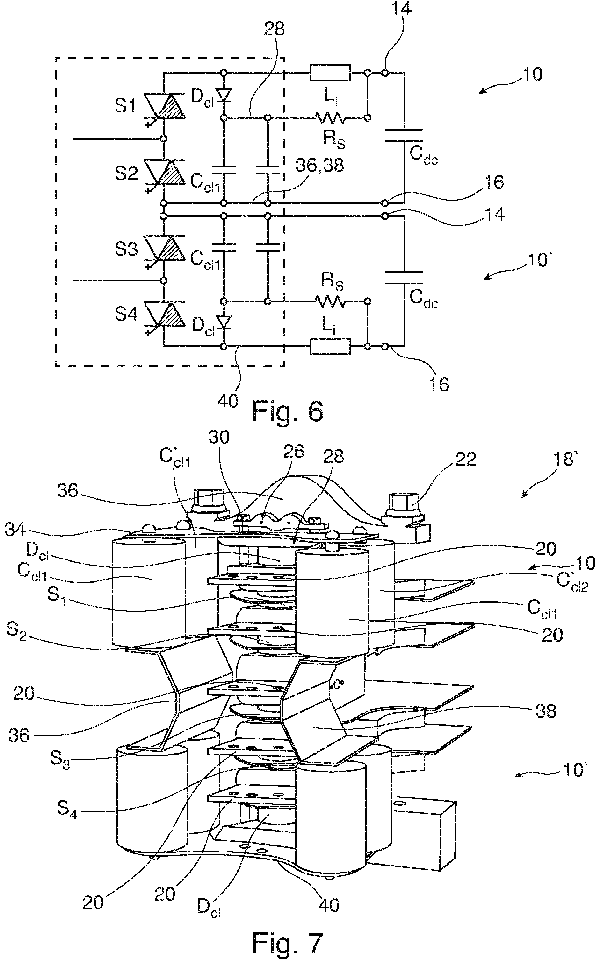

Die Fig. 6 zeigt ein Schaltdiagramm für den in der Fig. 7 gezeigten Presspack bzw. Stapel 18, der zwei in Reihe geschaltete Halbbrücken 10, 10' bzw. Zweipunktumrichter 10, 10' umfasst. Im dargestellten Beispiel sind die Halbleiterschalter S₁, S₂, S₃ und S₄ RC-IGCTs, können aber auch RC-IGBTs oder IGBT bzw. IGCT mit Dioden sein.

Die Halbleiterschalter S₁, S₂, S₃ und S₄ sind in Reihe geschaltet. Auch sind bei dem Umrichter 10, die Diode D_{cl}, die Drossel Lᵢ und der Widerstand Rs mit dem oberen, ersten Anschluss 14 verbunden, während bei dem Umrichter 10' diese Komponenten mit dem unteren, zweiten Anschluss 16 verbunden sind. es ist insbesondere keine zusätzliche Isolation zwischen den Umrichtern 10 und 10' notwendig. Die Umrichter 10 und 10' können einen Kühlkörper 20 bzw. eine Kühldose 20 gemeinsam nutzen.

In der Fig. 7 sind lediglich die in der Fig. 6 umrahmten Komponenten dargestellt. Die Snubber-Diode D_{cl} ist mit dem Halbleiterstapel 18 bzw. einer Montierklammer 26 verbunden. Das elektrisch leitende Kühlelement 20 zwischen der Snubber-Diode D_{cl} und dem Halbleiterschalter S₁ ist über eine leitende Verbindung 28 mit einer oberen, ersten Snubber-Busschiene 34 verbunden. Räumlich parallel zu dem Stapel 18 sind seitlich neben dem Stapel 18 vier Snubber-Kondensatoren C_{cl1}, C_{c12}, C_{cl1}', C_{c12}' angeordnet, die an einem oberen Ende mit der ersten Snubber-Busschiene 34 verbunden sind.

Die Kondensatoren C_{cl1}, C_{cl1}' sind dabei an einer Seite und die Kondensatoren C_{c12}, C_{cl2}' an der gegenüberliegenden Seite des Stapels 18 angeordnet.

An ihrem unteren Ende sind die Kondensatoren C_{cl1}, C_{cl1}' mit einer ersten mittleren Snubber-Busschiene 36 und die Kondensatoren C_{c12}, C_{c12}' mit einer zweiten mittleren Busschiene 38 verbunden. Die beiden Busschienen 36, 38 sind symmetrisch zueinander aufgebaut und weisen jeweils ein U-förmig gebogenes Blech auf. Mit dem Mittelteil sind die beiden Busschienen mit einem elektrisch leitenden Kühlelement 20 zwischen den Halbleiterschaltern S₂ und S₄ verbunden.

Eine untere, zweite Snubber-Busschiene 40 ist mit der Diode D_{cl} des zweiten Umrichters 10' verbunden. Die Kondensatoren C_{cl1}, C_{c12}, C_{cl1}', C_{c12}' des unteren Umrichters 10' sind mit dieser Diode D_{cl} über eine Busschiene 40 verbunden und den oberen Kondensatoren entsprechend angeordnet sowie entsprechend mit den mittleren Busschienen 36, 38 verbunden.

Für jeden der Umrichter 10, 10' sind in der Fig. 7 vier Kommutierungsschleifen zu erkennen.

### LISTE DER BEZUGSZEICHEN

- 10, 10': Zweipunktumrichter
- 12, 12': Kommutierungsschleife
- S₁, S₂: Halbleiterschalter
- C_{dc}: Zellkondensator
- L_{com}, L_{S}: Streuinduktivität
- C_{cl1}, C_{cl2}: Snubber-Kondensator
- D_{cl}: Snubber-Diode
- R_{S}: Snubber-Widerstand
- Lᵢ: Drossel-Induktivität
- 14, 16: Anschluss
- 18: Halbleiterstapel
- 20: Kühlelement
- 22: Rahmen
- 24: Hilfsstapel
- S₃, S₄: Halbleiterschalter
- 26: mechanische Montierklammer
- 28: elektrische Verbindung
- 34: obere, erste Snubber-Busschiene
- 36, 38: mittlere Snubber-Busschiene
- 40: untere, zweite Snubber-Busschiene

## Patentansprüche

1. Halbleiterstapel (18) für einen Umrichter (10), der Halbleiterstapel (18) umfassend:
zwei in Reihe geschaltete Halbleiterschalter (S₁, S₂);
zwei Anschlüsse (14, 16) zum Anschließen eines Zellenkondensators (C_{dc}), die von den beiden Halbleiterschaltern (S₁, S₂) miteinander verbunden werden;
wenigstens ein zwischen den Halbleiterschaltern (S₁, S₂) angeordnetes Kühlelement (20);
einen Rahmen (22), mit dem die Halbleiterschalter (S₁, S₂) und das Kühlelement (20) aneinander fixiert sind und der die Anschlüsse bereitstellt; und
wenigstens zwei mechanisch am Rahmen (22) fixierte Snubber-Kondensatoren (C_{cl1}, C_{cl2}), die parallel geschaltet sind, mit den Anschlüssen verbunden sind und die jeweils eine Kommutierungsschleife (12, 12') mit den beiden Halbleiterschaltern (S₁, S₂) bilden.

2. Halbleiterstapel (18) nach Anspruch 1, weiter umfassend:
wenigstens vier mechanisch am Rahmen (22) fixierte Snubber-Kondensatoren (C_{cl1}, C_{cl2}, C_{cl1}', C_{cl2}').

3. Halbleiterstapel (18) nach Anspruch 1 oder 2,
wobei zwei Snubber-Kondensatoren (C_{cl1}, C_{c12}) an gegenüberliegenden Seiten des Halbleiterstapels angeordnet sind.

4. Halbleiterstapel (18) nach einem der vorhergehenden Ansprüche,
wobei zwei Snubber-Kondensatoren (C_{cl1}, C_{cl1}') räumlich nebeneinander an einer Seite des Halbleiterstapels angeordnet sind.

5. Halbleiterstapel (18) nach einem der vorhergehenden Ansprüche,
wobei die Snubber-Kondensatoren (C_{cl1}, C_{c12}, C_{cl1}', C_{cl2}') gleichartig ausgeführt sind.

6. Halbleiterstapel (18) nach einem der vorhergehenden Ansprüche, weiter umfassend:
eine Snubber-Diode (D_{cl}) ; und/oder
einen Snubber-Widerstand (Rs) und/oder
eine Drossel-Induktivität (Lᵢ).

7. Halbleiterstapel (18) nach einem der vorhergehenden Ansprüche, weiter umfassend:
ein erstes Paar (S₁, S₂) und ein zweites Paar (S₃, S₄) von in Reihe geschalteten Halbleiterschaltern, die jeweils paarweise mit zwei Zellenkondensatoren (C_{dc}) verbindbar sind;
wenigstens zwei mechanisch am Rahmen (22) fixierte erste Snubber-Kondensatoren (C_{cl1}, C_{c12}, C_{cl1}', C_{cl2}'), die parallel geschaltet sind und die jeweils eine Kommutierungsschleife mit dem ersten Paar (S₁, S₂) von Halbleiterschaltern bilden; und
wenigstens zwei mechanisch am Rahmen (22) fixierte zweite Snubber-Kondensatoren (C_{cl1}, C_{c12}, C_{cl1}', C_{cl2}'), die parallel geschaltet sind und die jeweils eine Kommutierungsschleife mit dem zweiten Paar (S₃, S₄) von Halbleiterschaltern bilden.

8. Halbleiterstapel (18) nach einem der Ansprüche 7,
wobei die ersten Snubber-Kondensatoren (C_{cl1}, C_{c12}, C_{cl1}', C_{c12}') über eine erste Busschiene (34) miteinander verbunden sind, die zweiten Snubber-Kondensatoren (C_{cl1}, C_{c12}, C_{cl1}', C_{cl2}') über eine zweite Busschiene (40) miteinander verbunden sind und die ersten Snubber-Kondensatoren mit den zweiten Snubber-Kondensatoren über eine Busschiene (36, 38) miteinander verbunden sind, wobei die Busschiene (36, 38) an einem Kühlkörper (20) zwischen den Paaren von Halbleiterschaltern fixiert ist.

9. Halbleiterstapel (18) nach einem der vorhergehenden Ansprüche,
wobei die Halbleiterschalter (S₁, S₂, S₃, S₄) ausgewählt sind aus: Transistoren, Thyristoren, IGBTs, IGCTs, RC-IGBTs und/oder RC-IGCTs.

## Claims

1. Semiconductor stack (18) for a converter (10), the semiconductor stack (18) comprising:
two series-connected semiconductor switches (S₁, S₂) ;
two terminals (14, 16) for connecting a cell capacitor (C_{dc}), which are connected to one another by the two semiconductor switches (S₁, S₂) ;
at least one cooling element (20) arranged between the semiconductor switches (S₁, S₂) ;
a frame (22), by which the semiconductor switches (S₁, S₂) and the cooling element (20) are fixed to one another and which provides the terminals; and
at least two snubber capacitors (C_{cl1}, C_{cl2}) which are mechanically fixed to the frame (22) and which are connected in parallel, are connected to the terminals and which in each case form a commutation loop (12, 12') with the two semiconductor switches (S₁, S₂).

2. Semiconductor stack (18) according to Claim 1, further comprising:
at least four snubber capacitors (C_{cl1}, C_{cl2}, C_{cl1}', C_{cl2}') which are mechanically fixed to the frame (22).

3. Semiconductor stack (18) according to Claim 1 or 2,
wherein two snubber capacitors (C_{cl1}, C_{cl2}) are arranged on opposite sides of the semiconductor stack.

4. Semiconductor stack (18) according to any of the preceding claims,
wherein two snubber capacitors (C_{cl1}, C_{cl1}') are arranged spatially alongside one another on one side of the semiconductor stack.

5. Semiconductor stack (18) according to any of the preceding claims,
wherein the snubber capacitors (C_{cl1}, C_{cl2}, C_{cl1}', C_{cl2}') are embodied such that they are of identical type.

6. Semiconductor stack (18) according to any of the preceding claims, further comprising:
a snubber diode (D_{cl}) ; and/or
a snubber resistor (R_{S}) and/or
an inductor inductance (Lᵢ).

7. Semiconductor stack (18) according to any of the preceding claims, further comprising:
a first pair (S₁, S₂) and a second pair (S₃, S₄) of series-connected semiconductor switches, which are connectable in each case in pairs to two cell capacitors (C_{dc}) ;
at least two first snubber capacitors (C_{cl1}, C_{cl2}, C_{cl1}', C_{cl2}') which are mechanically fixed to the frame (22) and which are connected in parallel and which in each case form a commutation loop with the first pair (S₁, S₂) of semiconductor switches; and
at least two second snubber capacitors (C_{cl1}, C_{cl2}, C_{cl1}', C_{cl2}') which are mechanically fixed to the frame (22) and which are connected in parallel and which in each case form a commutation loop with the second pair (S₃, S₄) of semiconductor switches.

8. Semiconductor stack (18) according to any of Claims 7,
wherein the first snubber capacitors (C_{cl1}, C_{cl2}, C_{cl1}', C_{cl2}') are connected to one another via a first busbar (34), the second snubber capacitors (C_{cl1}, C_{cl2}, C_{cl1}', C_{cl2}') are connected to one another via a second busbar (40), and the first snubber capacitors together with the second snubber capacitors are connected to one another via a busbar (36, 38), wherein the busbar (36, 38) is fixed to a heat sink (20) between the pairs of semiconductor switches.

9. Semiconductor stack (18) according to any of the preceding claims,
wherein the semiconductor switches (S₁, S₂, S₃, S₄) are selected from: transistors, thyristors, IGBTs, IGCTs, RC-IGBTs and/or RC-IGCTs.

## Revendications

1. Empilement de semi-conducteurs (18) destiné à un convertisseur (10), l'empilement de semi-conducteurs (18) comprenant :
deux commutateurs à semi-conducteurs (S₁, S₂) connectés en série ;
deux bornes (14, 16) destinées à raccorder un condensateur à cellule (C_{dc}), qui sont connectées l'une à l'autre par les deux commutateurs à semi-conducteurs (S₁, S₂) ;
au moins un élément de refroidissement (20) disposé entre les commutateurs à semi-conducteurs (S₁, S₂) ;
un châssis (22) au moyen duquel les commutateurs à semi-conducteurs (S₁, S₂) et éléments de refroidissement (20) sont fixés les uns aux autres et qui fournit les bornes ; et
au moins deux condensateurs d'amortissement (C_{cl1}, C_{cl2}) fixés mécaniquement au châssis (22), qui sont connectés en parallèle, sont reliés aux bornes et forment respectivement avec les deux commutateurs à semi-conducteurs (S₁, S₂) une boucle de commutation (12, 12').

2. Empilement de semi-conducteurs (18) selon la revendication 1, comprenant en outre :
au moins quatre condensateurs d'amortissement (C_{cl1}, C_{cl2}, C_{cl1}', C_{cl2}') fixés mécaniquement au châssis (22).

3. Empilement de semi-conducteurs (18) selon la revendication 1 ou 2,
dans lequel deux condensateurs d'amortissement (C_{cl1}, C_{cl2}) sont disposés sur des côtés opposés de l'empilement de semi-conducteurs.

4. Empilement de semi-conducteurs (18) selon l'une quelconque des revendications précédentes,
dans lequel deux condensateurs d'amortissement (C_{cl1}, C_{cl1}') sont disposés spatialement côte à côte sur un côté de l'empilement de semi-conducteurs.

5. Empilement de semi-conducteurs (18) selon l'une quelconque des revendications précédentes,
dans lequel les condensateurs d'amortissement (C_{cl1}, C_{cl2}, C_{cl1}', C_{cl2}') sont réalisés de manière à être du même type.

6. Empilement de semi-conducteurs (18) selon l'une quelconque des revendications précédentes,
comprenant en outre :
une diode d'amortissement (D_{cl}) ; et/ou
une résistance d'amortissement (R_{S}) et/ou une inductance d'arrêt (Lᵢ).

7. Empilement de semi-conducteurs (18) selon l'une quelconque des revendications précédentes, comprenant en outre :
une première paire (S₁, S₂) et une deuxième paire (S₃, S₄) de commutateurs à semi-conducteurs connectés en série, qui peuvent respectivement être reliées par paires à deux condensateurs à cellules (C_{dc}) ;
au moins deux premiers condensateurs d'amortissement (C_{cl1}, C_{cl2}, C_{cl1}', C_{cl2}') fixés mécaniquement au châssis (22), qui sont connectés en parallèle et qui forment respectivement une boucle de commutation avec la première paire (S₁, S₂) de commutateurs à semi-conducteurs ; et
au moins deux deuxièmes condensateurs d'amortissement (C_{cl1}, C_{cl2}, C_{cl1}', C_{cl2}') fixés mécaniquement au châssis (22), qui sont connectés en série et qui forment respectivement une boucle de commutation avec la deuxième paire (S₃, S₄) de commutateurs à semi-conducteurs.

8. Empilement de semi-conducteurs (18) selon l'une quelconque des revendications 7,
dans lequel les premiers condensateurs d'amortissement (C_{cl1}, C_{cl2}, C_{cl1}', C_{cl2}') sont reliés les uns aux autres par l'intermédiaire d'une première barre omnibus (34), les deuxièmes condensateurs d'amortissement (C_{cl1}, C_{cl2}, C_{cl1}', C_{cl2}') sont reliés les uns aux autres par l'intermédiaire d'une deuxième barre omnibus (40) et les premiers condensateurs d'amortissement sont reliés les uns aux autres et aux deuxièmes condensateurs d'amortissement par l'intermédiaire d'une barre omnibus (36, 38), dans lequel la barre omnibus (36, 38) est fixée à un corps de refroidissement (20) entre les paires de commutateurs à semi-conducteurs.

9. Empilement de semi-conducteurs (18) selon l'une quelconque des revendications précédentes,
dans lequel les commutateurs à semi-conducteurs (S₁, S₂, S₃, S₄) sont sélectionnés parmi : des transistors, des thyristors, des IGBT, des IGCT, des RC-IGBT et/ou des RC-IGCT.
